# EUROPÄISCHE PATENTSCHRIFT

(11) **EP 4 109 194 B1**
(45) Veröffentlichungstag und Bekanntmachung des Hinweises auf die Patenterteilung: **18.10.2023**
(21) Anmeldenummer: 21181851.3
(22) Anmeldetag: 25.06.2021
(51) Int. Cl.: G05D 1/02

(54) **SENSORDATENGENERIERUNG ZUM STEUERN EINES AUTONOMEN FAHRZEUGS**
SENSOR DATA GENERATION FOR CONTROLLING AN AUTONOMOUS VEHICLE
GÉNÉRATION DES DONNÉES DE CAPTEUR PERMETTANT DE COMMANDER UN VÉHICULE AUTONOME

(43) Veröffentlichungstag der Anmeldung: 28.12.2022
(73) Patentinhaber: Siemens Aktiengesellschaft, 80333 München (DE)
(72) Erfinder: Botero Halblaub, Andrés, 85614 Kirchseeon (DE); Mayer, Hermann Georg, 83209 Prien am Chiemsee (DE); Wehrstedt, Jan Christoph, 81829 München (DE)
(74) Vertreter: Siemens Patent Attorneys

(56) Entgegenhaltungen:
- CN-A- 107 678 306
- US-A1- 2017 248 963
- US-A1- 2020 174 493
- GABB MICHAEL ET AL: "Infrastructure-supported Perception and Track-level Fusion using Edge Computing", 2019 IEEE INTELLIGENT VEHICLES SYMPOSIUM (IV), IEEE, 9. Juni 2019 (2019-06-09), Seiten 1739-1745, XP033606020, DOI: 10.1109/IVS.2019.8813886 [gefunden am 2019-08-26]

## Beschreibung

Die Erfindung betrifft ein computerimplementiertes Verfahren, eine Vorrichtung und ein Computerprogrammprodukt zum Generieren von Sensordaten zum Steuern eines autonomen Fahrzeugs in einer Umgebung, wie z.B. eines fahrerlosen Transportfahrzeugs (engl. Automated Guided Vehicle; AGV) in einer Fabrikanlage.

Produktionsvorgänge in Fabriken werden in der Regel vorab in einer virtuellen Umgebung simuliert (virtuelle Inbetriebnahme; engl. virtual commissioning), um vor einer realen Inbetriebnahme der Anlage das korrekte Zusammenspiel aller Komponenten zu gewährleisten, zeitliche Abläufe zu optimieren und potenzielle Fehler, wie z.B. Kollisionen, zu identifizieren. Dies stellt allerdings insbesondere bei Produktionsszenarien, wie z.B. bei einer individualisierten Produktion, eine Herausforderung dar, denn oft werden Produktionsabläufe mittels dynamischer Komponenten, insbesondere autonomer Fahrzeuge wie z.B. AGVs, durchgeführt. AGVs können beispielsweise Material an beliebigen Ausgabepunkten aufnehmen und an beliebige Stellen zur weiteren Produktion transportieren. Damit ist das Verhalten allerdings nicht mehr deterministisch und deshalb nicht im Vorfeld simulierbar. AGVs sind nicht mehr in fest vorgegebene Abläufe eingebunden und müssen daher durch Sensoren den Zustand ihrer Umgebung und ggf. ihre Position feststellen. Dies erfolgt in der Regel durch optische Sensoren wie Kameras, Lidar oder Laserentfernungsmessung. Für einen realistischen Test der AGVs in einer virtuellen Inbetriebnahme und/oder eine Steuerung der AGVs in der realen Produktionsumgebung, müssen Daten dieser Sensoren entsprechend vorliegen, um eine korrekte Reaktion des AGVs darauf bestimmen zu können. GABB MICHAEL ET AL: "Infrastructure-supported Perception and Track-level Fusion using Edge Computing", 2019 IEEE INTELLIGENT VEHICLES SYMPOSIUM (IV), IEEE, 9. Juni 2019 (2019-06-09), Seiten 1739-1745 offenbart eine Flotte autonomer Fahrzeuge, wobei Daten von Infrastruktursensoren der Umgebung mit Sensordaten der Fahrzeuge zusammengeführt werden.

Es ist daher eine Aufgabe der Erfindung, Sensordaten zum Steuern eines autonomen Fahrzeugs bereitzustellen.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein computerimplementiertes Verfahren zum Generieren von Sensordaten zum Steuern eines autonomen Fahrzeugs in einer Umgebung, in der sich mindestens ein weiteres autonomes Fahrzeug befindet, mit den Verfahrensschritten:
a) Einlesen eines Umgebungsmodells der Umgebung, wobei
   - das Umgebungsmodell ein globales Koordinatensystem aufweist und
   - das Umgebungsmodell erste Sensorpositionen von statischen Sensoren in der Umgebung und Umgebungsinformationen in diesem globalen Koordinatensystem und Sensorparameter der statischen Sensoren umfasst,
b) Generieren eines Zeitstempels,
c) Einlesen zweiter Sensorpositionen und Sensorparameter von Sensoren, die an die autonomen Fahrzeuge gekoppelt sind, und Bereitstellen der zweiten Sensorpositionen in Koordinaten des globalen Koordinatensystems,
d) Generieren von Sensordaten für die statischen Sensoren und die Sensoren der autonomen Fahrzeuge in Abhängigkeit der jeweiligen Sensorparameter und der jeweiligen ersten oder zweiten Sensorpositionen und unter Berücksichtigung der Umgebungsinformation in Koordinaten des globalen Koordinatensystems, wobei der generierte Zeitstempel den generierten Sensordaten zugeordnet wird,
e) Selektieren mindestens eines der autonomen Fahrzeuge,
f) Transformieren der generierten Sensordaten in ein lokales Koordinatensystem des selektierten autonomen Fahrzeugs, und
g) Senden der transformierten Sensordaten an eine Steuerung des selektierten autonomen Fahrzeugs zum Steuern des selektierten autonomen Fahrzeugs in der Umgebung in Abhängigkeit der transformierten Sensordaten.

Sofern es in der nachfolgenden Beschreibung nicht anders angegeben ist, beziehen sich die Begriffe "durchführen", "berechnen", "rechnergestützt", "rechnen", "feststellen", "generieren", "konfigurieren", "rekonstruieren" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter einer "Speichereinheit" kann im Zusammenhang mit der Erfindung beispielsweise ein flüchtiger Speicher in Form von Arbeitsspeicher (engl. Random-Access Memory, RAM) oder ein dauerhafter Speicher wie eine Festplatte oder ein Datenträger verstanden werden.

Unter einem "Modul" kann im Zusammenhang mit der Erfindung beispielsweise ein Prozessor zum Speichern von Programmbefehlen verstanden werden. Beispielsweise ist der Prozessor speziell dazu eingerichtet, die Programmbefehle derart auszuführen, damit der Prozessor Funktionen ausführt, um das erfindungsgemäße Verfahren oder einen Schritt des erfindungsgemäßen Verfahrens zu implementieren oder realisieren.

Unter "Bereitstellen", insbesondere in Bezug auf Daten und/oder Informationen, kann im Zusammenhang mit der Erfindung beispielsweise ein rechnergestütztes Bereitstellen verstanden werden. Das Bereitstellen erfolgt beispielsweise über eine Schnittstelle, wie z. B. eine Netzwerkschnittstelle, eine Kommunikationsschnittstelle oder eine Schnittstelle zu einer Speichereinheit. Über eine solche Schnittstelle können beispielsweise beim Bereitstellen entsprechende Daten und/oder Informationen übermittelt und/oder gesendet und/oder abgerufen und/oder empfangen werden.

Unter einem "technischen System" kann insbesondere eine Maschine, ein Gerät, oder auch eine Anlage umfassend mehrere Maschinen verstanden werden. Beispielsweise ist das technische System eine Produktionsmaschine oder eine Werkzeugmaschine.

Unter einer "Umgebung" kann im Zusammenhang mit der Erfindung beispielsweise ein Gebäude/Bauwerk, wie z.B. eine Fabrikanlage oder Produktionsanlage, oder eine Verkehrsinfrastruktur, sein. Die Umgebung ist beispielsweise durch Umgebungsmerkmale bzw. Umgebungsinformationen gekennzeichnet, wie z.B. Wege, Wände, Ecken, Hindernisse etc.

Unter einem "Umgebungsmodell" kann im Zusammenhang mit der Erfindung insbesondere ein computergestütztes/computerlesbares Modell bzw. Simulationsmodell verstanden werden, das Informationen, Merkmale und/oder Eigenschaften der Umgebung umfasst. Mit einem Umgebungsmodell kann insbesondere die Umgebung computergestützt simuliert bzw. abgebildet werden. Beispielsweise kann das Umgebungsmodell ein Bauwerksmodell eines Bauwerks, ein Infrastrukturmodell einer (Verkehrs-)Infrastruktur oder ein Gebäudemodell eines Gebäudes, wie z.B. einer Fabrikanlage/Produktionsanlage, sein. Vorzugsweise umfasst das Umgebungsmodell Umgebungsinformationen, wie z.B. Wege/Pfade, Hindernisse, etc. Umgebungsinformationen können auch als Bauwerksdaten/Gebäudedaten verstanden werden.

Unter einem "Sensor" kann insbesondere ein Detektor, ein Messgrößen- oder Messaufnehmer oder Messfühler verstanden werden. Ein physikalischer Sensor ist insbesondere eine Hardware-Komponente oder ein Hardware-Bauteil (Hardware-Sensor), das physikalische Größen quantitativ erfasst/misst. Der Sensor gibt einen Messwert oder Wert der Messgröße aus. Ein statischer Sensor hat insbesondere eine feste Position und/oder ein vorgegebenes Gesichtsfeld/Sichtfeld.

Unter einem "Zeitstempel" kann insbesondere ein digitaler Zeitstempel verstanden werden. Ein Zeitstempel kann insbesondere dazu genutzt werden, um einem Ereignis einen eindeutigen Zeitpunkt zuzuordnen. Vorzugsweise kann ein global gültiger Zeitstempel erzeugt und genutzt werden.

Es ist ein Vorteil der vorliegenden Erfindung, dass für einen gegebenen Zeitpunkt Sensordaten global für mehrere autonome Fahrzeuge gemeinsam und gleichzeitig generiert werden können. Die Sensordatengenerierung erfolgt dabei auf Basis eines Umgebungsmodells, das ein globales Koordinatensystem bereitstellt. Die derart generierten Sensordaten können für ein einzelnes Fahrzeug unter Einbeziehung einer sich ändernden Sensorposition und gegebenenfalls einer Zeitverzögerung umgerechnet werden. Dazu werden die generierten Sensordaten in ein lokales Koordinatensystem des autonomen Fahrzeugs transformiert.

Die Erfindung ermöglicht insbesondere, Sensordaten zur Steuerung von autonomen Fahrzeugen zu generieren. Beispielsweise können die Sensordaten für eine Steuerung und/oder eine virtuelle Inbetriebnahme von AGVs in einer Fabrik- oder Produktionsanlage genutzt werden. Für eine virtuelle Inbetriebnahme werden die Sensordaten vorzugsweise computergestützt simuliert. Alternativ können die Sensordaten auch für eine reale Steuerung von autonomen Fahrzeugen zentral generiert und über ein Kommunikationsnetzwerk an einzelne, autonome Fahrzeuge übermittelt werden. So kann ein einzelnes autonomes Fahrzeug Informationen von Sensoren erhalten, die nicht diesem Fahrzeug zugeordnet bzw. mit diesem gekoppelt sind. Dies verbessert insbesondere das Gesichtsfeld des Fahrzeugs und damit auch die Genauigkeit der Steuerung.

In einer Ausführungsform des Verfahrens kann das Umgebungsmodell ein computerlesbares Gebäudemodell sein.

Vorzugsweise handelt es sich bei dem computerlesbaren Gebäudemodell um ein sogenanntes BIM-Modell (Building Information Modelling, kurz: BIM), d.h. um ein Informationsmodell eines Gebäudes für eine digitale Gebäudemodellierung. Ein BIM-Modell umfasst vorzugsweise Sensorpositionen von statisch verbauten Sensoren sowie einen Typ des jeweiligen Sensors und weitere Sensorparameter. Das BIM-Modell kann dazu genutzt werden, ein globales Koordinatensystem festzulegen, in dem sich teilnehmende autonome Fahrzeuge bewegen können.

In einer weiteren Ausführungsform des Verfahrens können die Sensordaten für die statischen Sensoren und die Sensoren der autonomen Fahrzeuge zentral für einen Zeitstempel generiert werden.

Beispielsweise können die Sensordaten auf einer zentralen Recheneinheit, die vorzugsweise mit allen verfügbaren Sensoren zum Datenaustausch gekoppelt ist, generiert werden. Alternativ können die Sensordaten zentral für alle verfügbaren Sensoren simuliert werden. Damit liegen die Sensordaten zentral in einem globalen Koordinatensystem vor.

In einer weiteren Ausführungsform des Verfahrens, kann der Zeitstempel in vorgegebenen Zeitschritten aktualisiert werden und die Sensordaten können für den aktualisierten Zeitstempel erneut generiert werden.

So werden für jeden Zeitschritt Sensordaten generiert, die zur Steuerung mindestens eines autonomen Fahrzeugs genutzt werden können.

In einer weiteren Ausführungsform des Verfahrens können die Sensordaten unter Berücksichtigung einer Sendelatenz für das Senden der Sensordaten an das selektierte autonome Fahrzeug in das lokale Koordinatensystem des selektierten autonomen Fahrzeugs transformiert werden.

Dadurch können Sensordaten für einen vorgegebenen Zeitschritt prognostiziert werden. Beispielsweise kann derart eine Bewegung extrapoliert werden.

In einer weiteren Ausführungsform des Verfahrens können die Sensordaten in Abhängigkeit von generierten Sensordaten, denen ein vorhergehender Zeitstempel zugeordnet ist, in das lokale Koordinatensystem des selektierten autonomen Fahrzeugs transformiert werden.

Dadurch kann beispielsweise eine Geschwindigkeit eines detektierten Objekts bestimmt und bei der Koordinatentransformation berücksichtigt werden.

In einer weiteren Ausführungsform des Verfahrens können die Sensordaten mittels einer computergestützten Sensorsimulation generiert werden.

Mittels einer computergestützten Sensorsimulation können Daten von modellierten Sensoren generiert werden. Eine Sensorsimulation kann insbesondere in Abhängigkeit von Umgebungsinformationen, die z.B. durch das Umgebungsmodell bereitgestellt werden, durchgeführt werden. Beispielsweise können mit einer Sensorsimulation Daten, die ein Sensor an einer vorgegebenen Position in Abhängigkeit eines vorgegebenen Sensortyps, Gesichtsfeld, Sensitivität, etc. detektiert, computergestützt simuliert werden. In anderen Worten, eine computergestützte Sensorsimulation liefert beispielsweise Ausgabewerte eines Sensors unter Berücksichtigung der Umgebungsinformation. Insbesondere können bei einer Sensorsimulation weitere Informationen, wie z.B. Geschwindigkeit eines Fahrzeugs, eine Lenkbewegung, etc., berücksichtigt werden.

In einer weiteren Ausführungsform des Verfahrens kann eine Qualität von mindestens einem Teil der generierten Sensordaten verringert werden und diese modifizierten Sensordaten können mit geringerer Qualität in das lokale Koordinatensystem des selektierten autonomen Fahrzeugs transformiert werden.

Beispielsweise kann ein Rauschsignal auf die generierten Sensordaten moduliert werden und/oder ein Sichtbereich des jeweiligen Sensors kann (künstlich) eingeschränkt werden. Insbesondere bei einer Sensordatengenerierung mittels einer computergestützten Sensorsimulation können die generierten Daten derart modifiziert und dadurch realistischer dargestellt werden.

In einer weiteren Ausführungsform des Verfahrens können die generierten Sensordaten in Abhängigkeit der Position des selektierten autonomen Fahrzeugs im globalen Koordinatensystem gefiltert und lediglich die gefilterten Sensordaten in das lokale Koordinatensystem des selektierten autonomen Fahrzeugs transformiert und an das selektierte autonome Fahrzeug übermittelt werden.

Dies ermöglicht insbesondere lediglich diejenigen Sensordaten an das Fahrzeug zu übermitteln, die für das Fahrzeug relevant sind.

In einer weiteren Ausführungsform des Verfahrens können die statischen Sensoren und die Sensoren der autonomen Fahrzeuge und/oder die autonomen Fahrzeuge über ein Kommunikationsnetzwerk miteinander verbunden sein.

Beispielsweise kann es sich bei einem solchen Kommunikationsnetzwerk um ein 5G-Netzwerk handeln. Durch die Vernetzung können die Sensordaten zentral generiert und anschließend an die jeweiligen Fahrzeuge übermittelt werden.

In einer weiteren Ausführungsform des Verfahrens kann das selektierte autonome Fahrzeug in einer Simulationsumgebung in Abhängigkeit der transformierten Sensordaten gesteuert werden.

Beispielsweise kann es sich hierbei um eine virtuelle Inbetriebnahme des autonomen Fahrzeugs handeln. Dazu kann eine Bewegung des autonomen Fahrzeugs in der Umgebung simuliert werden, wobei die simulierten Sensordaten genutzt werden, um Reaktionen des autonomen Fahrzeugs zu steuern.

In einer weiteren Ausführungsform des Verfahrens kann die Umgebung eine Fabrikanlage sein und die autonomen Fahrzeuge können fahrerlose Transportfahrzeuge (engl. Automated Guided Vehicles, AGVs) sein.

Gemäß einem zweiten Aspekt betrifft die Erfindung eine Vorrichtung zum Generieren von Sensordaten zum Steuern eines autonomen Fahrzeugs in einer Umgebung, in der sich mindestens ein weiteres autonomes Fahrzeug befindet, wobei die Vorrichtung umfasst:
a) eine erste Schnittstelle, die derart eingerichtet ist, ein Umgebungsmodell der Umgebung einzulesen, wobei
   - das Umgebungsmodell ein globales Koordinatensystem aufweist und
   - das Umgebungsmodell erste Sensorpositionen von statischen Sensoren in der Umgebung und Umgebungsinformationen in diesem globalen Koordinatensystem und Sensorparameter der statischen Sensoren umfasst,
b) einen Zeitstempelgenerator, der derart eingerichtet ist, einen Zeitstempel zu generieren,
c) eine zweite Schnittstelle, die derart eingerichtet ist, zweite Sensorpositionen und Sensorparameter von Sensoren, die an die autonomen Fahrzeuge gekoppelt sind, einzulesen und die zweiten Sensorpositionen in Koordinaten des globalen Koordinatensystems bereitzustellen,
d) einen Sensordatengenerator, der derart eingerichtet ist, Sensordaten für die statischen Sensoren und die Sensoren der autonomen Fahrzeuge in Abhängigkeit der jeweiligen Sensorparameter und der jeweiligen ersten oder zweiten Sensorpositionen und unter Berücksichtigung der Umgebungsinformation in Koordinaten des globalen Koordinatensystems zu generieren, wobei der generierte Zeitstempel den generierten Sensordaten zugeordnet wird,
e) ein Selektionsmodul, das derart eingerichtet ist, mindestens eines der autonomen Fahrzeuge zu selektierten,
f) ein Transformationsmodul, das derart eingerichtet ist, die generierten Sensordaten in ein lokales Koordinatensystem des selektierten autonomen Fahrzeugs zu transformieren, und
g) ein Sendemodul, das derart eingerichtet ist, die transformierten Sensordaten an eine Steuerung des selektierten autonomen Fahrzeugs zum Steuern des selektierten autonomen Fahrzeugs in der Umgebung in Abhängigkeit der transformierten Sensordaten zu senden.

Die Vorrichtung kann insbesondere mit der Steuerung des selektierten autonomen Fahrzeugs, z.B. über ein Kommunikationsnetzwerk, gekoppelt sein, um die Sensordaten zu übermitteln.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, die Schritte eines erfindungsgemäßen Verfahrens auszuführen.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele der Erfindung sind in den Zeichnungen beispielhaft dargestellt und werden anhand der nachfolgenden Beschreibung näher erläutert. Es zeigen:
- Fig. 1:: ein erstes Ausführungsbeispiel eines erfindungsgemäßen Verfahrens;
- Fig. 2:: ein erstes Ausführungsbeispiel einer erfindungsgemäßen Vorrichtung;
- Fig. 3:: ein zweites Ausführungsbeispiel einer erfindungsgemäßen Vorrichtung;
- Fig. 4:: ein zweites Ausführungsbeispiel eines erfindungsgemäßen Verfahrens; und
- Fig. 5:: ein drittes Ausführungsbeispiel eines erfindungsgemäßen Verfahrens.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

Insbesondere können diese gebräuchlichen und dem Fachmann bekannten Realisierungsvarianten ausschließlich per Hardware(komponenten) oder ausschließlich per Software(komponenten) realisiert werden. Alternativ und/oder zusätzlich kann der Fachmann im Rahmen seines fachmännischen Könnens weitestgehend beliebige erfindungsgemäße Kombinationen aus Hardware(komponenten) und Software(komponenten) wählen, um erfindungsgemäße Realisierungsvarianten umzusetzen.

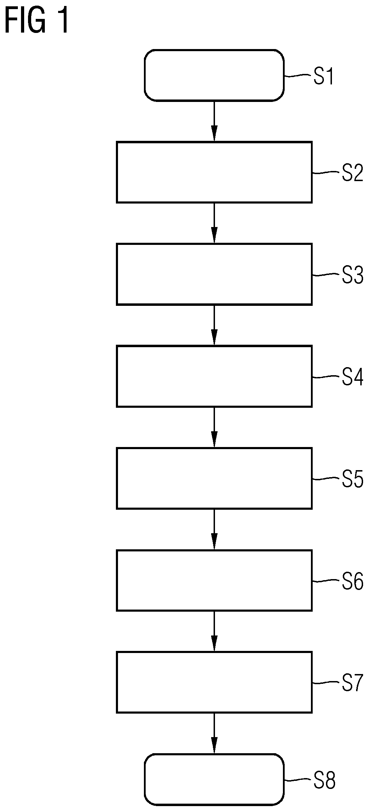

Figur 1 zeigt ein Flussdiagramm als erstes Ausführungsbeispiel eines erfindungsgemäßen Verfahrens zum Generieren von Sensordaten zum Steuern eines autonomen Fahrzeugs in einer Umgebung. Beispielsweise kann das Steuern eines autonomen Fahrzeugs in einer Umgebung computergestützt simuliert werden. Die Umgebung kann beispielsweise ein Gebäude oder eine Verkehrsinfrastruktur sein. In der Umgebung befinden sich vorzugsweise eine Vielzahl von autonomen Fahrzeugen (engl. "autonomous vehicles", AVs), wie z.B. autonome Transportfahrzeuge (engl. "automated guided vehicles", AGVs).

Es sollen Sensordaten, die zur Steuerung eines dieser autonomen Fahrzeuge genutzt werden können, erzeugt werden. Das autonome Fahrzeug kann beispielsweise in einer simulierten Umgebung anhand der Sensordaten (virtuell) gesteuert werden, d.h. die Bewegung und/oder Steuerung des autonomen Fahrzeugs in der Umgebung kann anhand der generierten Sensordaten computergestützt simuliert werden. Alternativ können die generierten Sensordaten auch zur Steuerung des autonomen Fahrzeugs in der realen Umgebung genutzt werden.

Im ersten Schritt S1 wird ein Umgebungsmodell der Umgebung eingelesen. Beispielsweise ist das Umgebungsmodell ein BIM-Modell des Gebäudes. Das Umgebungsmodell weist ein globales Koordinatensystem auf, d.h. insbesondere sind Positionen von Umgebungsmerkmalen, wie z.B. Wege, Wände, Hindernisse etc., in diesem Koordinatensystem gegeben und im Umgebungsmodell gespeichert. Außerdem umfasst das Umgebungsmodell erste Sensorpositionen von statischen Sensoren, wie z.B. fest verbaute Kameras, in der Umgebung und das Umgebungsmodell umfasst Sensorparameter der statischen Sensoren. Ein statischer Sensor ist insbesondere nicht beweglich, d.h. ändert seine Sensorposition und/oder sein Gesichtsfeld vorzugsweise nicht. Ein Sensorparameter kann beispielsweise ein Gesichtsfeld, eine Sensitivität, einen Sensortyp, eine Auflösung, etc. sein. Ein Sensorparameter ist einem jeweiligen Sensor vorzugsweise eindeutig zugeordnet.

Vorzugsweise umfasst das Umgebungsmodell alle Sensorinformationen der statischen Sensoren in der Umgebung, wie z.B. des Gebäudes bzw. in dem Gebäude.

Im nächsten Schritt S2 wird ein Zeitstempel generiert. Vorzugsweise werden die folgenden Schritte S3 bis S7 für diesen Zeitstempel durchgeführt, d.h. bei einer Aktualisierung des Zeitstempels werden die Schritte für den aktualisierten Zeitstempel wiederholt.

Im nächsten Schritt S3 werden zweite Sensorpositionen und Sensorparameter von Sensoren, die an die autonomen Fahrzeuge gekoppelt sind, eingelesen. Die autonomen Fahrzeuge umfassen vorzugsweise Sensoren, wie z.B. Kameras oder Entfernungsmessgeräte, die beispielsweise an einem jeweiligen autonomen Fahrzeug angebracht sind. Die Sensorpositionen der jeweiligen Sensoren sind somit abhängig von den Positionen der jeweiligen Fahrzeuge. Die Sensoren der autonomen Fahrzeuge können auch als bewegliche Sensoren bezeichnet werden, da die Sensorposition und/oder das Gesichtsfeld dieser Sensoren sich mit der Zeit ändern können. Die Sensorpositionen der Sensoren der autonomen Fahrzeuge und/oder die Positionen der autonomen Fahrzeuge werden für den generierten Zeitstempel in Koordinaten des globalen Koordinatensystems bereitgestellt.

Im nächsten Schritt S4 werden Sensordaten für die statischen Sensoren und die (beweglichen) Sensoren der autonomen Fahrzeuge in Abhängigkeit der jeweiligen Sensorparameter der jeweiligen Sensoren und in Abhängigkeit der jeweiligen ersten Sensorpositionen der statischen Sensoren oder der zweiten Sensorpositionen der beweglichen Sensoren in Koordinaten des globalen Koordinatensystems und unter Berücksichtigung der Umgebungsinformation generiert. Außerdem wird der generierte Zeitstempel den generierten Sensordaten zugeordnet. In anderen Worten, die Sensordaten werden für diesen Zeitschritt generiert und erhalten den generierten Zeitstempel.

Beispielsweise werden für eine fest an einem autonomen Fahrzeug installierte Kamera Sensordaten generiert, d.h. es werden Daten generiert, die die Kamera in Abhängigkeit der Kameraposition, des Kamerablickfelds, der Kamerasensitivität etc. ausgibt. Bei der Sensordatengenerierung werden insbesondere Umgebungsinformationen, wie z.B. ein Hindernis, berücksichtigt. Folglich können die generierten Kameradaten das Hindernis oder Informationen zu dem Hindernis umfassen, wenn sich das Hindernis zu dem gegebenen Zeitpunkt im Kamerablickfeld befindet.

Es werden Sensordaten für alle vorhandenen Sensoren generiert, wobei Umgebungsinformationen der Umgebung aus dem Umgebungsmodell berücksichtigt werden. Außerdem können Positionsinformationen der autonomen Fahrzeuge bei der Sensordatengenerierung berücksichtigt werden.

Vorzugsweise werden die Sensordaten zentral generiert und bereitgestellt. Die Sensordaten können beispielsweise zentral mittels einer Sensorsimulation generiert werden.

Im nächsten Schritt S5 wird mindestens eines der autonomen Fahrzeuge selektiert. Die Selektion kann anhand einer vorgegebenen Reihenfolge, anhand eines Selektionskriteriums oder zufällig erfolgen.

Im nächsten Schritt S6 werden die generierten Sensordaten in ein lokales Koordinatensystem des selektierten autonomen Fahrzeugs transformiert. So werden beispielsweise Sensordaten einer statischen Kamera in das Koordinatensystem des selektierten Fahrzeugs transformiert, so dass diese Daten aus Sicht des Fahrzeugs vorliegen.

Im nächsten Schritt S7 werden die transformierten Sensordaten an eine Steuerung des selektierten autonomen Fahrzeugs übermittelt.

Im nächsten Schritt S8 kann das selektierte Fahrzeug in Abhängigkeit der transformierten Sensordaten in der Umgebung gesteuert werden. Alternativ oder zusätzlich können die transformierten Sensordaten für ein Training einer künstlichen Intelligenz, wie z.B. eines künstlichen, neuronalen Netzes, genutzt werden, das beispielsweise dazu eingerichtet ist, eine Steuerung eines autonomen Fahrzeugs zu unterstützen. So kann anhand der generierten Sensordaten ein maschinelles Lernverfahren trainiert werden, das Prädiktionen zur Planung mit Kombination der Simulation besser trifft und die Begebenheiten und Gepflogenheiten einer speziellen Umgebung anpasst. Es kann beispielsweise ein hybrider Model-Predictive-Control-Ansatz aus künstlicher Intelligenz und einem Simulationsmodell verwendet werden.

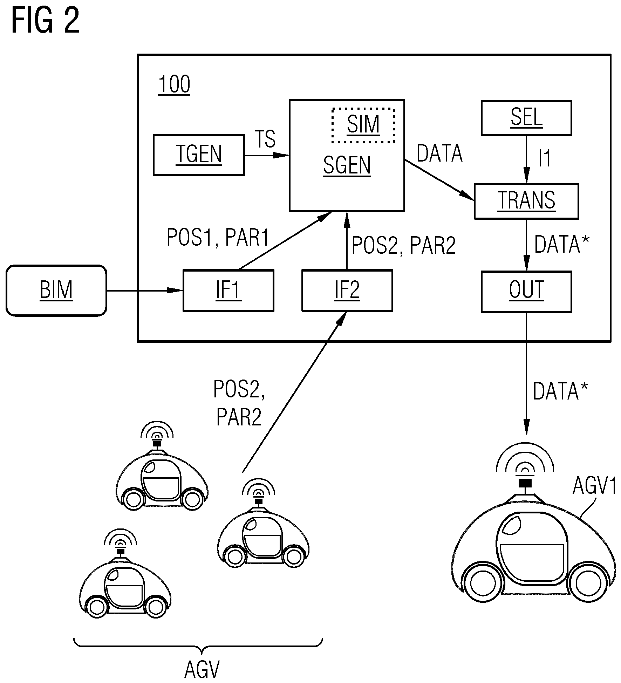

Figur 2 zeigt in schematischer Darstellung ein Ausführungsbeispiel einer erfindungsgemäßen Vorrichtung 100 zum Generieren von Sensordaten zum Steuern eines autonomen Fahrzeugs AGV1 in einer Umgebung. In der Umgebung, z.B. eine Fabrikanlage oder eine Verkehrsinfrastruktur, bewegen sich beispielsweise eine Vielzahl von autonomen Fahrzeugen. Zur Steuerung der autonomen Fahrzeuge sind Sensordaten notwendig. Die Vorrichtung 100 ist dazu eingerichtet, solche Sensordaten zentral für die autonomen Fahrzeuge AGV zu generieren und auszugeben.

Die Vorrichtung 100 kann beispielsweise mittels einer Sensorsimulation SIM Sensordaten generieren. Diese generierten bzw. simulierten Sensordaten können beispielsweise für eine computergestützte Simulation der Bewegung und/oder Steuerung der autonomen Fahrzeuge genutzt werden, wie z.B. für eine virtuelle Inbetriebnahme der autonomen Fahrzeuge.

Alternativ kann die Vorrichtung 100 Sensordaten zentral für die autonomen Fahrzeuge AGV generieren und bereitstellen. Dazu kann die die Vorrichtung 100 vorzugsweise über ein 5G-Kommunikationsnetzwerk mit den autonomen Fahrzeugen AGV und/oder den statischen Sensoren in der Umgebung vernetzt sein.

Die Vorrichtung 100 umfasst eine erste Schnittstelle IF1, eine zweite Schnittstelle IF2, einen Zeitstempelgenerator TGEN, einen Sensordatengenerator SGEN, ein Selektionsmodul SEL, ein Transformationsmodul TRANS und ein Sendemodul OUT.

Die erste Schnittstelle IF1 ist dazu eingerichtet, ein Umgebungsmodell BIM der Umgebung einzulesen, wobei das Umgebungsmodell BIM ein globales Koordinatensystem aufweist und das Umgebungsmodell erste Sensorpositionen POS1 von statischen Sensoren in der Umgebung und Umgebungsinformationen in diesem globalen Koordinatensystem und Sensorparameter PARI dieser statischen Sensoren umfasst. Das Umgebungsmodell kann beispielsweise ein digitales Informationsmodell der Umgebung sein. Beispielswiese ist das Umgebungsmodell ein BIM-Modell, wenn die Umgebung ein Gebäude/Bauwerk ist. Beispielsweise kann es sich um eine Produktionsanlage handeln, in der sich AGVs bewegen.

Der Zeitstempelgenerator TGEN ist dazu eingerichtet, einen globalen Zeitstempel TS zu generieren. Der Zeitstempel TS wird dazu benötigt, generierten Sensordaten einen eindeutigen, globalen Zeitpunkt zuzuordnen. Der Zeitstempel kann in vorgegebenen Zeitschritten aktualisiert werden. Bei Aktualisierung des Zeitstempels TS werden die Sensordaten für den aktualisierten Zeitstempel erneut generiert.

Die zweite Schnittstelle IF2 ist dazu eingerichtet, zweite Sensorpositionen POS2 und Sensorparameter PAR2 von Sensoren, die an die autonomen Fahrzeuge AGV gekoppelt sind, einzulesen und die zweiten Sensorpositionen in Koordinaten des globalen Koordinatensystems bereitzustellen.

Der Sensordatengenerator SGEN ist dazu eingerichtet, Sensordaten DATA für die statischen Sensoren und die Sensoren der autonomen Fahrzeuge in Abhängigkeit der jeweiligen Sensorparameter PAR1, PAR2 und der jeweiligen ersten oder zweiten Sensorpositionen POS1, POS2 in Koordinaten des globalen Koordinatensystems zu generieren, wobei der generierte Zeitstempel TS den generierten Sensordaten zugeordnet wird.

Die Sensordaten DATA können beispielsweise mittels einer computergestützten Sensorsimulation SIM erzeugt werden. Außerdem kann eine Qualität der generierten Sensordaten verringert und derart bereitgestellt werden. Die Qualität der simulierten Sensordaten kann dadurch an eine realistische Qualität realer Daten nachempfunden werden.

Insbesondere kann anhand der generierten Sensordaten mindestens ein Umgebungsmerkmal detektiert werden. Ein Umgebungsmerkmal kann beispielsweise ein Hindernis, eine Wand, eine Engstelle etc. sein. Ein Umgebungsmerkmal kann auch eine Person sein, die sich in der Umgebung bewegt. So kann eine Position des Umgebungsmerkmals in Koordinaten des globalen Koordinatensystems bereitgestellt werden.

Das Selektionsmodul SEL ist dazu eingerichtet, mindestens eines der autonomen Fahrzeuge zu selektierten und eine Information I1 über diese Selektion an das Transformationsmodul TRANS zu übermitteln.

Das Transformationsmodul TRANS ist dazu eingerichtet, die generierten Sensordaten DATA und/oder die detektierten Umgebungsmerkmale in ein lokales Koordinatensystem des selektierten autonomen Fahrzeugs AGV1 zu transformieren. Bei der Koordinatentransformation kann insbesondere eine Sendelatenz, die bei einer Übermittlung der Sensordaten an das selektierte Fahrzeug auftritt, berücksichtigt werden. Für die Transformation wird dem Transformationsmodul TRANS die Information I1 über das selektierte Fahrzeug und mindestens die Position des selektierten Fahrzeugs für den gültigen Zeitstempel übermittelt. Das Transformationsmodul TRANS transformiert vorzugsweise alle Sensordaten DATA in das lokale Koordinatensystem des selektierten autonomen Fahrzeugs AGV1, die für das selektierte Fahrzeug AGV1 relevant sind. Beispielsweise können die generierten Sensordaten DATA in Abhängigkeit der Position des selektierten autonomen Fahrzeugs im globalen Koordinatensystem gefiltert und lediglich die gefilterten Sensordaten DATA in das lokale Koordinatensystem des selektierten autonomen Fahrzeugs AGV1 transformiert und an das selektierte autonome Fahrzeug AGV1 übermittelt werden.

Die Sensordaten DATA können insbesondere auch in Abhängigkeit von vorab generierten, weiteren Sensordaten, denen ein vorhergehender Zeitstempel zugeordnet ist, in das lokale Koordinatensystem des selektierten autonomen Fahrzeugs transformiert werden. Beispielsweise kann anhand der vorab generierten Sensordaten neue Sensordaten für den aktuellen Zeitstempel extrapoliert werden.

Wenn anhand der Sensordaten ein Umgebungsmerkmal detektiert wurde, kann insbesondere lediglich das Umgebungsmerkmal in das lokale Koordinatensystem transformiert werden.

Das Sendemodul OUT ist dazu eingerichtet, die transformierten Sensordaten DATA* an eine Steuerung des selektierten autonomen Fahrzeugs AGV1 zum Steuern des selektierten autonomen Fahrzeugs in der Umgebung in Abhängigkeit der transformierten Sensordaten DATA* zu übermitteln.

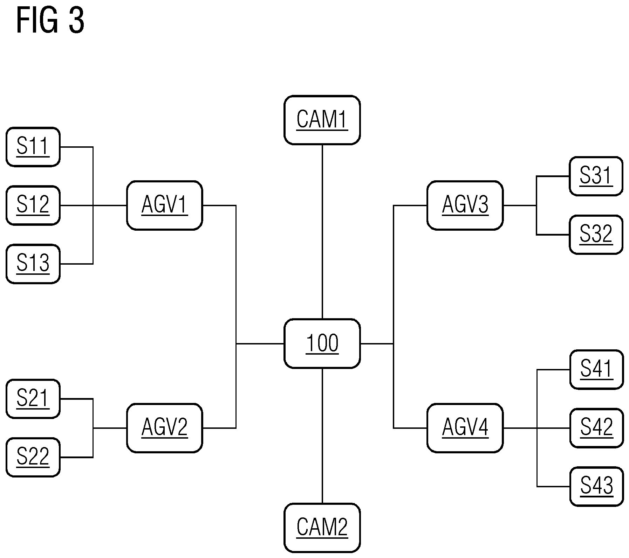

Figur 3 zeigt in schematischer Darstellung ein weiteres Ausführungsbeispiel einer erfindungsgemäßen Vorrichtung 100 zum Generieren von Sensordaten zum Steuern eines autonomen Fahrzeugs in einer Umgebung, in der sich mindestens ein weiteres autonomes Fahrzeug befindet. Beispielsweise handelt es sich um eine Fabrik, in der sich autonome Transportfahrzeuge AGV1, AGV2, AGV3, AGV4 bewegen.

Die Vorrichtung 100 kann insbesondere zum Generieren von Sensordaten mittels einer Sensorsimulation eingerichtet sein. Figur 2 zeigt einen logischen Aufbau eines solchen Simulationssystems. Die Sensordaten werden nicht aus der Sicht eines einzelnen autonomen Transportfahrzeugs AGV1, AGV2, AGV3, AGV4 simuliert, sondern zentral für alle Transportfahrzeuge gleichzeitig. Die autonomen Fahrzeuge AGV1, AGV2, AGV3, AGV4 sind vorzugsweise dazu mit der Vorrichtung 100 gekoppelt.

Vorzugsweise liegt für die Fabrik ein BIM-Modell vor. Aus dem BIM-Modell können die Sensorpositionen von statisch verbauten Sensoren CAM1, CAM2 bestimmt werden, sowie der Typ des jeweiligen Sensors und weitere Parameter, wie z.B. sichtbare Bereiche einer Kamera CAM1, CAM2. Das BIM-Modell wird zudem dafür verwendet ein globales Koordinatensystem festzulegen, in dem sich die autonomen Transportfahrzeuge AGV1, AGV2, AGV3, AGV4 bewegen können. Vorzugsweise können die autonomen Transportfahrzeuge ohne größere Verzögerung auf dieselben Daten zugreifen können. Dies kann z.B. durch ein breitbandiges 5G-Netzwerk im Fabrikumfeld erreicht werden. Alternativ oder zusätzlich kann auch eine beliebige Zeitverzögerung simulativ erzeugt und berücksichtigt werden, sobald die Daten in die Sicht eines einzelnen zu steuernden AGVs umgerechnet werden.

Zunächst werden alle Sensordaten der statischen Sensoren CAM1, CAM2 und der beweglichen Sensoren S11, S12, S21, ...S23, S31, S32, S41, ... S43 der autonomen Transportfahrzeuge AGV1, ..., AGV4 mit einem globalen Zeitstempel erzeugt. Der Zeitstempel kann in diskreten Schritten erhöht werden, je nachdem wie genau die erforderliche zeitliche Auflösung festgelegt wurde (z.B. basierend auf der Geschwindigkeit der AGVs oder anderer Komponenten einer Produktionsanlage). Zusätzlich werden die jeweiligen Sensorpositionen der Sensoren in einem globalen Koordinatensystem abgespeichert. Eine Sensorposition eines beweglichen Sensors kann sich beispielsweise von Zeitstempel zu Zeitstempel ändern, z.B. wenn der Sensor zum Beispiel auf einem fahrenden Transportfahrzeug montiert ist.

Die generierten Sensordaten können an alle am Sensornetzwerk beteiligten autonomen Fahrzeuge AGV1, ..., AGV4 verteilt werden. Dazu werden die Sensordaten in ein lokales Koordinatensystem des jeweiligen autonomen Fahrzeugs transformiert. Die Verteilung kann aber auch auf die Fahrzeuge einschränken, die möglicherweise von den Daten beeinflusst sind. Eine Beeinflussung lässt sich beispielsweise anhand des BIM-Modells abschätzen. Liegt z.B. eine Entfernung eines Transportfahrzeugs von einem Sensor über einen bestimmten Schwellwert, so können die Daten dieses Sensors zunächst vernachlässigt werden. Im Fall einer Beeinflussung werden die Daten in das lokale Koordinatensystem des betrachteten Transportfahrzeugs transformiert. Dafür kann auch eine bestimmte Latenzzeit eingerechnet werden. Diese führt dann z.B. zu einer Extrapolation einer Bewegung in die Zukunft. Die transformierten Daten werden nun an das aktuell betrachtete Transportfahrzeug übertragen und können von diesem ausgewertet werden.

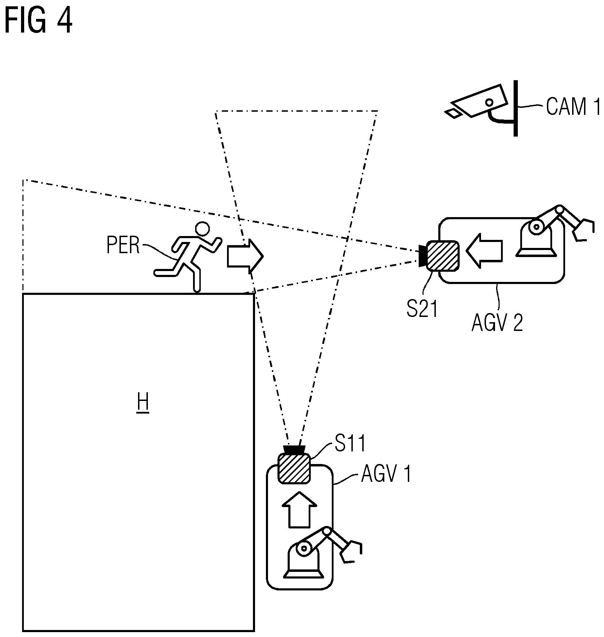

Figur 4 zeigt in schematischer Darstellung ein weiteres Ausführungsbeispiel eines erfindungsgemäßen Verfahrens.

Es ist ein Gebäude, wie z.B. eine Produktionsanlage, gezeigt, in dem sich zwei autonome Transportfahrzeuge AGV1, AGV2 und eine Person PER bewegen können. Die Transportfahrzeuge AGV1, AGV2 umfassen jeweils mindestens einen Sensor S11, S21, wie z.B. eine Kamera. Weiter umfasst das Gebäude eine statisch installierte Kamera CAM1. Die jeweiligen Kameras verfügen über ein vorgegebenes Gesichtsfeld.

Es sollen die beiden autonomen Fahrzeuge AGV1, AGV2 virtuell in Betrieb genommen werden, d.h. es soll eine computergestützte Simulation einer Bewegung und/oder eines Verhaltens der autonomen Fahrzeuge AGV1, AGV2 in dem Gebäude unter Berücksichtigung der Gebäudemerkmale H und/oder der Bewegung der Person PER durchgeführt werden. Dazu werden simulierte Sensordaten der vorhandenen Sensoren benötigt, um beispielsweise eine Reaktion eines der autonomen Fahrzeuge auf die Person PER zu simulieren.

Dazu werden Sensordaten anhand der Informationen eines digitalen Gebäudemodells des Gebäudes zentral für alle statischen und beweglichen Sensoren zu einem vorgegebenen Zeitpunkt simuliert. Dabei wird die Position der Person PER und/oder der autonomen Fahrzeuge AGV1, AGV2 berücksichtigt. Dafür wird ein globaler Zeitstempel definiert.

Fr die Sensordatengenerierung werden die Sensorpositionen des statischen Sensors CAM1 und der Sensoren S11, S21 der autonomen Fahrzeuge AGV1, AGV2 eingelesen und in einem durch das Gebäudemodell vorgegebenen globalen Koordinatensystem bereitgestellt. Anschließend werden dann Sensordaten in Abhängigkeit der jeweiligen Sensorparameter und der jeweiligen Sensorpositionen und unter Berücksichtigung der Gebäudemerkmale H und/oder der Person PER in Koordinaten des globalen Koordinatensystems generiert, wobei der generierte Zeitstempel den generierten Sensordaten zugeordnet wird.

Die generierten Sensordaten können anschließend in ein lokales Koordinatensystem des ersten autonomen Fahrzeugs AGV1 transformiert und diesem übermittelt werden. So erhält das erste autonome Fahrzeug AGV1 auch Sensordaten des Sensors S21 des zweiten autonomen Fahrzeugs AGV2. AGV1 kann somit in Abhängigkeit der transformierten Sensordaten gesteuert werden. Beispielsweise erhält AGV1 somit auch Informationen über die Person PER, die hinter einem Hindernis H nicht vom Sensor S11 des ersten autonomen Fahrzeugs AGV1 erfasst wird. Diese zusätzlichen Sensordaten können bei der Steuerung/virtuellen Inbetriebnahme des ersten autonomen Fahrzeugs AGV1 berücksichtigt werden.

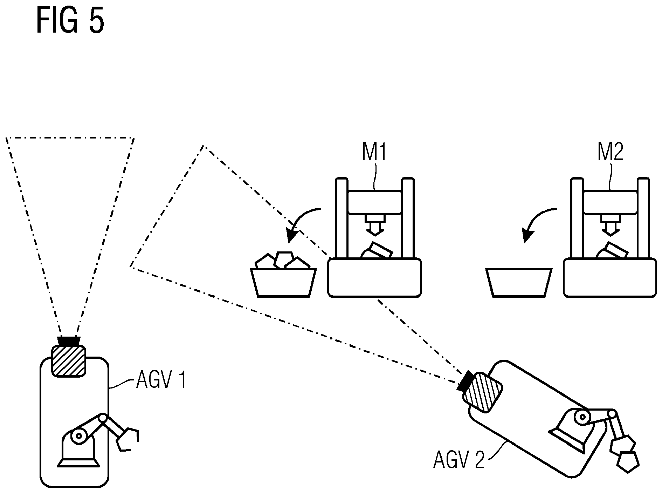

Figur 5 zeigt in schematischer Darstellung ein weiteres Ausführungsbeispiel des erfindungsgemäßen Verfahrens.

Es ist eine Produktionsanlage gezeigt, die zwei Produktionsmaschinen M1, M2, sowie zwei autonome Transportfahrzeuge AGV1, AGV2 umfasst.

Die Erfindung ermöglicht beispielsweise eine verteilte Lagerhaltung bzw. eine Simulation einer verteilten Lagerhaltung, die mit autonomen Transportfahrzeugen AGV1, AGV2 verwaltet wird. Sensoren der autonomen Fahrzeuge AGV1, AGV2 können beispielsweise einen Lagerbestand an verschiedenen Maschinen M1, M2 detektieren.

Beispielsweise kann ein erstes Transportfahrzeug AGV1 ein volles Lager an einer ersten Maschine M1 über die Sensorik von des zweiten autonomen Transportfahrzeugs AGV2 aufnehmen. Dies wird durch eine zentrale Sensordatengenerierung aller Sensoren in einem globalen Koordinatensystem mit anschließender Transformation der generierten Sensordaten in ein lokales Koordinatensystem des ersten autonomen Transportfahrzeugs ermöglicht.

So kann, während das zweite autonome Transportfahrzeug AGV2 keine Transportkapazitäten frei hat, das erste autonome Transportfahrzeug AGV1 ein Überlaufen des Lagers der ersten Maschine M1 verhindern und die Produktion kann so ohne Unterbrechung weiterlaufen.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Computerimplementiertes Verfahren zum Generieren von Sensordaten zum Steuern eines autonomen Fahrzeugs in einer Umgebung, in der sich mindestens ein weiteres autonomes Fahrzeug befindet, mit den Verfahrensschritten:
a) Einlesen (S1) eines Umgebungsmodells der Umgebung, wobei
- das Umgebungsmodell ein globales Koordinatensystem aufweist und
- das Umgebungsmodell erste Sensorpositionen von statischen Sensoren in der Umgebung und Umgebungsinformationen in diesem globalen Koordinatensystem und Sensorparameter der statischen Sensoren umfasst,
b) Generieren (S2) eines Zeitstempels,
c) Einlesen (S3) zweiter Sensorpositionen und Sensorparameter von Sensoren, die an die autonomen Fahrzeuge gekoppelt sind, und Bereitstellen der zweiten Sensorpositionen in Koordinaten des globalen Koordinatensystems,
d) Generieren (S4) von Sensordaten für die statischen Sensoren und die Sensoren der autonomen Fahrzeuge in Abhängigkeit der jeweiligen Sensorparameter und der jeweiligen ersten oder zweiten Sensorpositionen und unter Berücksichtigung der Umgebungsinformation in Koordinaten des globalen Koordinatensystems, wobei der generierte Zeitstempel den generierten Sensordaten zugeordnet wird,
e) Selektieren (S5) mindestens eines der autonomen Fahrzeuge,
f) Transformieren (S6) der generierten Sensordaten in ein lokales Koordinatensystem des selektierten autonomen Fahrzeugs, und
g) Senden (S7) der transformierten Sensordaten an eine Steuerung des selektierten autonomen Fahrzeugs zum Steuern des selektierten autonomen Fahrzeugs in der Umgebung in Abhängigkeit der transformierten Sensordaten.

2. Computerimplementiertes Verfahren nach Anspruch 1, wobei das Umgebungsmodell ein computerlesbares Gebäudemodell ist.

3. Computerimplementiertes Verfahren nach einem der vorhergehenden Ansprüche, wobei die Sensordaten für die statischen Sensoren und die Sensoren der autonomen Fahrzeuge zentral für einen Zeitstempel generiert werden.

4. Computerimplementiertes Verfahren nach einem der vorhergehenden Ansprüche, wobei der Zeitstempel in vorgegebenen Zeitschritten aktualisiert wird und die Sensordaten für den aktualisierten Zeitstempel erneut generiert werden.

5. Computerimplementiertes Verfahren nach einem der vorhergehenden Ansprüche, wobei die Sensordaten unter Berücksichtigung einer Sendelatenz für das Senden der Sensordaten an das selektierte autonome Fahrzeug in das lokale Koordinatensystem des selektierten autonomen Fahrzeugs transformiert werden.

6. Computerimplementiertes Verfahren nach einem der vorhergehenden Ansprüche, wobei die Sensordaten in Abhängigkeit von generierten Sensordaten, denen ein vorhergehender Zeitstempel zugeordnet ist, in das lokale Koordinatensystem des selektierten autonomen Fahrzeugs transformiert werden.

7. Computerimplementiertes Verfahren nach einem der vorhergehenden Ansprüche, wobei die Sensordaten mittels einer computergestützten Sensorsimulation generiert werden.

8. Computerimplementiertes Verfahren nach einem der vorhergehenden Ansprüche, wobei eine Qualität von mindestens einem Teil der generierten Sensordaten verringert wird und diese modifizierten Sensordaten mit geringerer Qualität in das lokale Koordinatensystem des selektierten autonomen Fahrzeugs transformiert werden.

9. Computerimplementiertes Verfahren nach einem der vorhergehenden Ansprüche, wobei anhand der generierten Sensordaten mindestens ein Umgebungsmerkmal detektiert wird und lediglich das detektierte Umgebungsmerkmal in das lokale Koordinatensystem des selektierten autonomen Fahrzeugs transformiert wird.

10. Computerimplementiertes Verfahren nach einem der vorhergehenden Ansprüche, wobei die generierten Sensordaten in Abhängigkeit der Position des selektierten autonomen Fahrzeugs im globalen Koordinatensystem gefiltert und lediglich die gefilterten Sensordaten in das lokale Koordinatensystem des selektierten autonomen Fahrzeugs transformiert und an das selektierte autonome Fahrzeug übermittelt werden.

11. Computerimplementiertes Verfahren nach einem der vorhergehenden Ansprüche, wobei die statischen Sensoren und die Sensoren der autonomen Fahrzeuge und/oder die autonomen Fahrzeuge über ein Kommunikationsnetzwerk miteinander verbunden sind.

12. Computerimplementiertes Verfahren nach einem der vorhergehenden Ansprüche, wobei das selektierte autonome Fahrzeug in einer Simulationsumgebung in Abhängigkeit der transformierten Sensordaten gesteuert wird.

13. Computerimplementiertes Verfahren nach einem der vorhergehenden Ansprüche, wobei die Umgebung eine Fabrikanlage ist und die autonomen Fahrzeuge fahrerlose Transportfahrzeuge sind.

14. Vorrichtung (100) zum Generieren von Sensordaten zum Steuern eines autonomen Fahrzeugs in einer Umgebung, in der sich mindestens ein weiteres autonomes Fahrzeug befindet, wobei die Vorrichtung umfasst:
a) eine erste Schnittstelle (IF1), die derart eingerichtet ist, ein Umgebungsmodell (BIM) der Umgebung einzulesen, wobei
- das Umgebungsmodell (BIM) ein globales Koordinatensystem aufweist und
- das Umgebungsmodell (BIM) erste Sensorpositionen von statischen Sensoren in der Umgebung und Umgebungsinformationen in diesem globalen Koordinatensystem und Sensorparameter der statischen Sensoren umfasst,
b) einen Zeitstempelgenerator (TGEN), der derart eingerichtet ist, einen Zeitstempel zu generieren,
c) eine zweite Schnittstelle (IF2), die derart eingerichtet ist, zweite Sensorpositionen und Sensorparameter von Sensoren, die an die autonomen Fahrzeuge gekoppelt sind, einzulesen und die zweiten Sensorpositionen in Koordinaten des globalen Koordinatensystems bereitzustellen,
d) einen Sensordatengenerator (SGEN), der derart eingerichtet ist, Sensordaten für die statischen Sensoren und die Sensoren der autonomen Fahrzeuge in Abhängigkeit der jeweiligen Sensorparameter und der jeweiligen ersten oder zweiten Sensorpositionen und unter Berücksichtigung der Umgebungsinformation in Koordinaten des globalen Koordinatensystems zu generieren, wobei der generierte Zeitstempel den generierten Sensordaten zugeordnet wird,
e) ein Selektionsmodul (SEL), das derart eingerichtet ist, mindestens eines der autonomen Fahrzeuge zu selektierten,
f) ein Transformationsmodul (TRANS), das derart eingerichtet ist, die generierten Sensordaten in ein lokales Koordinatensystem des selektierten autonomen Fahrzeugs zu transformieren, und
g) ein Sendemodul (OUT), das derart eingerichtet ist, die transformierten Sensordaten an eine Steuerung des selektierten autonomen Fahrzeugs zum Steuern des selektierten autonomen Fahrzeugs in der Umgebung in Abhängigkeit der transformierten Sensordaten zu senden.

15. Computerprogrammprodukt, das direkt in einen programmierbaren Computer ladbar ist, umfassend Programmcodeteile, die dazu geeignet sind, die Schritte des Verfahrens nach einem der Ansprüche 1 bis 13 durchzuführen.

## Claims

1. Computer-implemented method for generating sensor data for controlling an autonomous vehicle in an environment in which at least one further autonomous vehicle is situated, with the following method steps:
a) reading in (S1) an environment model of the environment, wherein
- the environment model has a global coordinate system and
- the environment model comprises first sensor positions of static sensors in the environment and environment information in this global coordinate system and sensor parameters of the static sensors,
b) generating (S2) a time stamp,
c) reading in (S3) second sensor positions and sensor parameters of sensors, which are coupled to the autonomous vehicles, and providing the second sensor positions in coordinates of the global coordinate system,
d) generating (S4) sensor data for the static sensors and the sensors of the autonomous vehicles as a function of the respective sensor parameters and the respective first or second sensor positions and taking into account the environment information in coordinates of the global coordinate system, wherein the generated time stamp is assigned to the generated sensor data,
e) selecting (S5) at least one of the autonomous vehicles,
f) transforming (S6) the generated sensor data into a local coordinate system of the selected autonomous vehicle, and
g) transmitting (S7) the transformed sensor data to a controller of the selected autonomous vehicle for controlling the selected autonomous vehicle in the environment as a function of the transformed sensor data.

2. Computer-implemented method according to claim 1, wherein the environment model is a computer-readable building model.

3. Computer-implemented method according to one of the preceding claims, wherein the sensor data for the static sensors and the sensors of the autonomous vehicles are centrally generated for a time stamp.

4. Computer-implemented method according to one of the preceding claims, wherein the time stamp is updated in predefined time increments and the sensor data is generated anew for the updated time stamp.

5. Computer-implemented method according to one of the preceding claims, wherein the sensor data is transformed into the local coordinate system of the selected autonomous vehicle by taking into account a transmission latency for transmitting the sensor data to the selected autonomous vehicle.

6. Computer-implemented method according to one of the preceding claims, wherein the sensor data is transformed into the local coordinate system of the selected autonomous vehicle as a function of generated sensor data, to which a preceding time stamp is assigned.

7. Computer-implemented method according to one of the preceding claims, wherein the sensor data is generated by means of a computer-aided sensor simulation.

8. Computer-implemented method according to one of the preceding claims, wherein a quality of at least some of the generated sensor data is reduced and this modified sensor data with lower quality is transformed into the local coordinate system of the selected autonomous vehicle.

9. Computer-implemented method according to one of the preceding claims, wherein on the basis of the generated sensor data at least one environmental feature is detected and only the detected environmental feature is transformed into the local coordinate system of the selected autonomous vehicle.

10. Computer-implemented method according to one of the preceding claims, wherein the generated sensor data is filtered as a function of the position of the selected autonomous vehicle in the global coordinate system and only the filtered sensor data is transformed into the local coordinate system of the selected autonomous vehicle and transferred to the selected autonomous vehicle.

11. Computer-implemented method according to one of the preceding claims, wherein the static sensors and the sensors of the autonomous vehicles and/or the autonomous vehicles are connected together by a communications network.

12. Computer-implemented method according to one of the preceding claims, wherein the selected autonomous vehicle is controlled in a simulation environment as a function of the transformed sensor data.

13. Computer-implemented method according to one of the preceding claims, wherein the environment is a factory and the autonomous vehicles are driverless transport vehicles.

14. Apparatus (100) for generating sensor data for controlling an autonomous vehicle in an environment in which least one further autonomous vehicle is situated, wherein the apparatus comprises:
a) a first interface (IF1), which is adapted to read in an environment model (BIM) of the environment, wherein
- the environment model (BIM) has a global coordinate system and
- the environment model (BIM) comprises first sensor positions of static sensors in the environment and environment information in this global coordinate system and sensor parameters of the static sensors,
b) a time stamp generator (TGEN), which is adapted to generate a time stamp,
c) a second interface (IF2), which is adapted to read in second sensor positions and sensor parameters of sensors, which are coupled to the autonomous vehicles, and to provide the second sensor positions in coordinates of the global coordinate system,
d) a sensor data generator (SGEN), which is adapted to generate sensor data for the static sensors and the sensors of the autonomous vehicles as a function of the respective sensor parameters and the respective first or second sensor positions and taking into account the environment information in coordinates of the global coordinate system, wherein the generated time stamp is assigned to the generated sensor data,
e) a selection module (SEL), which is adapted to select at least one of the autonomous vehicles,
f) a transformation module (TRANS), which is adapted to transform the generated sensor data into a local coordinate system of the selected autonomous vehicle, and
g) a transmission module (OUT), which is adapted to transmit the transformed sensor data to a controller of the selected autonomous vehicle for controlling the selected autonomous vehicle in the environment as a function of the transformed sensor data.

15. Computer program product, which can be directly loaded into a programmable computer, comprising program code components, which are capable of carrying out the steps of the method according to one of claims 1 to 13.

## Revendications

1. Procédé mis en oeuvre par ordinateur de création de données de capteur pour la commande d'un véhicule autonome dans un environnement, dans lequel se trouve au moins un autre véhicule autonome, comprenant les stades de procédé :
a) lecture (S1) d'un modèle de l'environnement, dans lequel
- le modèle de l'environnement a un système global de coordonnées, et
- le modèle de l'environnement comprend des premières positions de capteurs statiques dans l'environnement et des informations d'environnement dans ce système global de coordonnées et des paramètres des capteurs statiques,
b) création (S2) d'une estampille temporelle,
c) lecture (S3) de deuxièmes positions et paramètres de capteurs, qui sont couplés aux véhicules autonome et mise à disposition des deuxièmes positions de capteur dans des coordonnées du système global de coordonnées,
d) création (S4) de données de capteur pour les capteurs statiques et les capteurs des véhicules autonomes, en fonction des paramètres respectifs de capteur et des premières ou deuxièmes positions respectives de capteur et en tenant compte de l'information de l'environnement dans des coordonnées du système global de coordonnées, dans lequel on affecte l'estampille temporelle créée aux données de capteur créées,
e) sélection (S5) d'au moins l'un des véhicules autonomes,
f) transformation (S6) des données de capteur créées dans un système local de coordonnées du véhicule autonome sélectionné, et
g) envoi (S7) des données de capteur transformées à une commande du véhicule autonome sélectionné pour la commande du véhicule autonome sélectionné dans l'environnement en fonction des données de capteur transformées.

2. Procédé mis en oeuvre par ordinateur suivant la revendication 1, dans lequel le modèle de l'environnement est un modèle de bâtiments déchiffrable par ordinateur.

3. Procédé mis en oeuvre par ordinateur suivant l'une des revendications précédentes, dans lequel on crée les données de capteur pour les capteurs statiques et les données des véhicules autonomes centralement pour une estampille temporelle.

4. Procédé mis en oeuvre par ordinateur suivant l'une des revendications précédentes, dans lequel on met à jour l'estampille temporelle dans des stades temporels donnés à l'avance et on crée à nouveau les données de capteur pour l'estampille temporelle mise à jour.

5. Procédé mis en oeuvre par ordinateur suivant l'une des revendications précédentes, dans lequel on transforme, dans le système local de coordonnées du véhicule autonome sélectionné, les données de capteur en tenant compte d'une latence d'envoi pour l'envoi des données de capteur au véhicule autonome sélectionné.

6. Procédé mis en oeuvre par ordinateur suivant l'une des revendications précédentes, dans lequel on transforme, dans le système local de coordonnées du véhicule autonome sélectionné, les données de capteur en fonction de données de capteur créées, auxquelles est affectée une estampille temporelle précédente.

7. Procédé mis en oeuvre par ordinateur suivant l'une des revendications précédentes, dans lequel on crée les données de capteur au moyen d'une simulation de capteur assistée par ordinateur.

8. Procédé mis en oeuvre par ordinateur suivant l'une des revendications précédentes, dans lequel on diminue une qualité d'au moins une partie des données de capteur créées et on transforme ces données de capteur modifiées de moindre qualité dans système local de coordonnées du véhicule autonome sélectionné.

9. Procédé mis en oeuvre par ordinateur suivant l'une des revendications précédentes, dans lequel on détecte au moins une caractéristique de l'environnement à l'aide des données de capteur créées et on transforme seulement la caractéristique de l'environnement détectée dans le système local de coordonnées du véhicule autonome sélectionné.

10. Procédé mis en oeuvre par ordinateur suivant l'une des revendications précédentes, dans lequel on filtre les données de capteur créées en fonction de la position du véhicule autonome sélectionné dans le système global de coordonnées et on transforme et transmet au véhicule autonome sélectionné seulement les données de capteur filtrées dans le système local de coordonnées du véhicule autonome sélectionné.

11. Procédé mis en oeuvre par ordinateur suivant l'une des revendications précédentes, dans lequel les capteurs statiques et les capteurs des véhicules autonomes et/ou les véhicules autonomes sont reliés entre eux par un réseau de communication.

12. Procédé mis en oeuvre par ordinateur suivant l'une des revendications précédentes, dans lequel on commande le véhicule autonome sélectionné dans un environnement de simulation en fonction des données de capteur transformées.

13. Procédé mis en oeuvre par ordinateur suivant l'une des revendications précédentes, dans lequel l'environnement est une installation de fabrique et les véhicules autonomes sont des véhicules de transport sans conducteur.

14. Système (100) de création de données de capteur pour la commande d'un véhicule autonome dans un environnement, dans lequel se trouve au moins un autre véhicule autonome, dans lequel le système comprend :
a) une première interface (IF1), qui est agencée de manière à lire un modèle (BIM) de l'environnement, dans lequel
- le modèle (BIM) de l'environnement a un système global de coordonnées, et
- le modèle (BIM) de l'environnement comprend des premières positions de capteurs statiques dans l'environnement et des informations d'environnement dans ce système global de coordonnées et des paramètres des capteurs statiques,
b) un générateur (TGEN) d'estampille temporel, qui est agencé pour créer une estampille temporelle,
c) une deuxième interface (IF2), qui est agencée pour lire des deuxièmes positions et paramètres de capteurs, qui sont couplés au véhicule autonome, et pour donner les deuxièmes positions de capteurs dans des coordonnées du système global de coordonnées,
d) un créateur (SGEN) de données de capteur, qui est agencé pour créer, dans des coordonnées du système global de coordonnées, des données pour les capteurs statiques et les capteurs des véhicules autonomes, en fonction des paramètres respectifs de capteurs et des premières ou deuxièmes positions respectives de capteur et en tenant compte de l'information d'environnement, dans lequel on associe les données de capteur créées à l'estampille temporelle créée,
e) un module (SEL) de sélection, qui est agencé pour sélectionner au moins l'un des véhicules autonomes,
f) un module (TRANS) de transformation, qui est agencé pour transformer les données de capteur créées dans un système local de coordonnées du véhicule autonome sélectionné, et
g) un module (OUT) d'envoi, qui est agencé pour envoyer les données de capteur transformées à une commande du véhicule autonome sélectionné, pour la commande du véhicule autonome sélectionnée dans l'environnement, en fonction des données de capteur transformées.

15. Produit de programme d'ordinateur, qui peut être chargé directement dans un ordinateur programmable, comprenant des parties de code de programme, qui sont propres à effectuer les stades du procédé suivant l'une des revendications 1 à 13.
